Europäisches Patentamt

European Patent Office

Office européen des brevets

(19)

(11) Publication number: **0 080 254**
A2

(12) **EUROPEAN PATENT APPLICATION**

(21) Application number: 82304367.4

(22) Date of filing: 18.08.82

(51) Int. Cl.³: **H 03 K 19/088**, H 03 K 19/013

(30) Priority: 18.08.81 JP 129154/81

(43) Date of publication of application: 01.06.83
Bulletin 83/22

(84) Designated Contracting States: DE FR GB

(71) Applicant: FUJITSU LIMITED, 1015, Kamikodanaka
Nakahara-ku, Kawasaki-shi Kanagawa 211 (JP)

(72) Inventor: Omichi, Hitoshi, Dai-2-Taihei-50 203,
Shukugawara, Tama-ku Kawasaki-shi
Kanagawa 214 (JP)
Inventor: Tanizawa, Tetsu,
Dai-2-Yurigaoka-ryo, 2-7-5 Chiyogaoka, Asao-ku
Kawasaki-shi Kanagawa 215 (JP)
Inventor: Mitono, Yoshiharu, 1-14-12, Sakuragaoka,
Setagaya-ku Tokyo 156 (JP)

(74) Representative: Fane, Christopher Robin King et al,
HASELTINE LAKE & CO. Hazlitt House 28 Southampton
Buildings Chancery Lane, London, WC2A 1AT (GB)

(54) Transistor-transistor logic circuit.

(57)   A transistor-transistor logic circuit comprises an input transistor ($Q_1$) having at least one emitter which serves as an input (IN) and a collector controlling the base current of an output transistor ($Q_2$) having a collector which serves as an output (OUT). A series circuit of a Schottky barrier diode (SBD) and a PN junction diode (D) is provided between the collector and emitter of the output transistor so as to clamp the high-level of the output.

EP 0 080 254 A2

# TRANSISTOR-TRANSISTOR LOGIC CIRCUIT

The present invention relates to a transistor- -transistor logic (TTL) circuit,and more particularly to a clamp circuit for clamping the high-level output thereof.

Transistor-transistor logic circuits are well- -known in the art. A typical TTL circuit comprises an input transistor having at least one emitter for receiving an input signal. The input transistor generates an output at its collector so as to control the base current of an output transistor. As a result, the potential at the collector of the output transistor serves as an output of the TTL circuit. In order to enhance the operation speed of the TTL circuit, a clamp circuit may be provided between the collector and emitter of the output transistor. In this case, the high-level output is clamped so as to minimize the swing or amplitude of the output signal. Further, in order to improve the performance of a TTL circuit, it is preferable that the threshold voltage of an input signal be the center value of the output amplitude.

For example, a clamp circuit can comprise a series circuit of a PN junction diode and a resistor. In this case, the value of the resistor is determined so as to fix the threshold voltage of the input signal at the center value of the output amplitude. In a TTL circuit using such a series circuit as a clamp circuit, however, the noise margins are small due to the linear V-I characteristics of the resistor. Note that the noise margins are defined as follows: a low-level noise margin is the difference between the maximum low-level input signal voltage and the threshold input voltage, and a high-level noise margin is the difference between the minimum high-level input signal and the threshold input voltage.

A clamp circuit has been proposed using two diodes connected in series, which can improve noise margins. In such a TTL circuit, however, the threshold voltage of the input signal is usually below the center value of the output amplitude since, usually, an input transistor, an output transistor, and diodes which are also comprised of diode-connected transistors, have about the same dimensions, which will be explained later in more detail. Further, the two diodes of the clamp circuit must be formed in individual isolated regions, which can be disadvantageous in respect to high integration.

It is desirable to provide a TTL circuit in which the threshold voltage of the input signal is the center value of the output amplitude, and which can be highly integrated.

According to the present invention, there is provided a TTL circuit comprising: first and second power supply terminals; an input terminal; an output terminal; first and second impedance means; an input transistor having a base connected by the first impedance means to the first power supply terminal, a collector, and at least one emitter connected to the input terminal; an output transistor having a base connected to the collector of the input transistor, a collector connected to the output terminal and by the second impedance means to the first power supply terminal, a base connected to the collector of the input transistor, and an emitter connected to the second power supply terminal; a Schottky barrier diode having an anode connected to the collector of the output transistor and a cathode; and a PN junction diode having an anode connected to the cathode of the Schottky barrier diode and a cathode connected to the emitter of the output transistor.

- 3 -

0080254

Reference will now be made, by way of example, to the accompanying drawings, wherein:

Figure 1 is a circuit diagram illustrating a first prior art TTL circuit;

Fig. 2 is a circuit diagram illustrating a second prior art TTL circuit;

Fig. 3 is a circuit diagram illustrating another TTL circuit;

Fig. 4 is a circuit diagram illustrating an embodiment of a TTL circuit according to the present invention;

Fig. 5 is a plane view of the clamp circuit of Fig. 4; and

Fig. 6 is a cross-sectional view taken along the line VI-VI of Fig. 5.

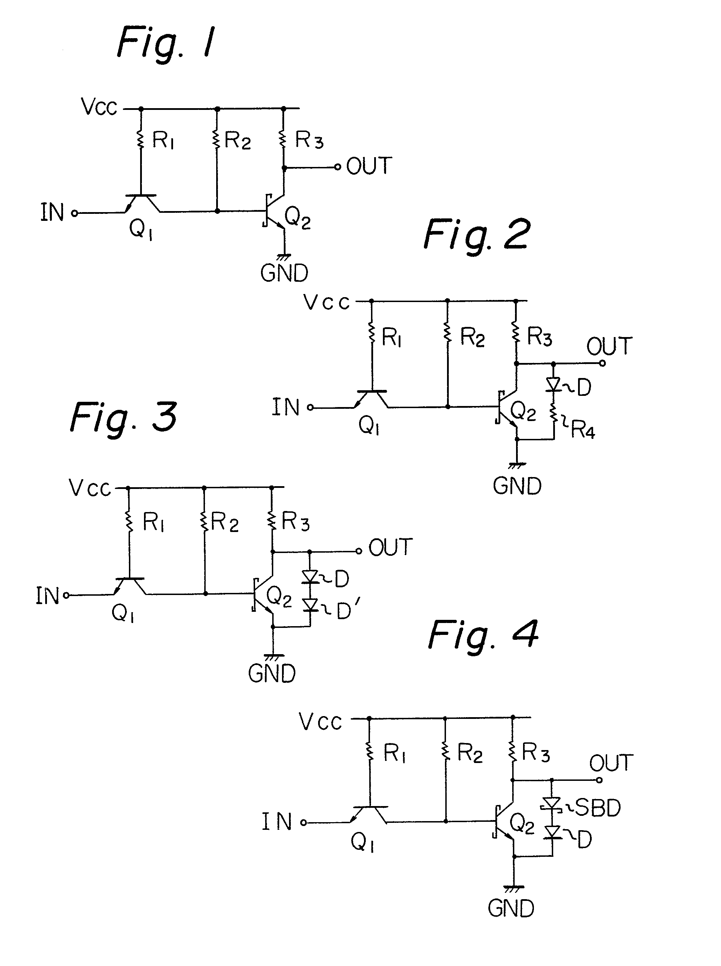

In Fig. 1, which illustrates a prior circuit, $Q_1$ and $Q_2$ are input and output transistors, respectively and; $R_1$, $R_2$, and $R_3$ are resistors. Note that the transistor $Q_2$ is preferably a Schottky barrier diode transistor so as to enhance the operation speed. $V_{CC}$ and GND designate power supplies.

In Fig. 1, when the potential of an input signal IN is low, a current flows from the power supply $V_{CC}$ through the resistor $R_1$ to the emitter side of the transistor $Q_1$ so that the transistor $Q_2$ is turned off, and, accordingly, the potential of an output signal OUT becomes high. Contrary to this, when the potential of the input signal IN is high, a current flows from the power supply $V_{CC}$ through the base and collector of the transistor $Q_1$ to the base of the transistor $Q_2$ so that the transistor $Q_2$ is turned on, and, accordingly, the potential of the output signal OUT becomes low. Thus, the TTL circuit of Fig. 1 serves as an inverter circuit. Note that if the input transistor $Q_1$ is a multi-emitter-type transistor, the TTL circuit of Fig. 1 serves as a NAND circuit.

In Fig. 1, the low-level, $V_{OL}$, of the output signal OUT is the collector-emitter voltage $V_{CE}$ ($\simeq 0.4$ V) of the transistor $Q_2$ while the high-level, $V_{OH}$, of the output signal OUT is $V_{CC}$ , which means that the output amplitude is large, which can reduce the operation speed.

In the circuits of Figs. 2 and 3, a clamp circuit is provided so as to clamp the high-level $V_{OH}$ of the output signal OUT, to increase the operation speed, that is, the speed of transition of the output signal OUT from high to low.

In Fig. 2, the clamp circuit comprises a series circuit of a PN junction diode D and a resistor $R_4$. The high--level $V_{OH}$ of the output signal OUT can be clamped at, for example, about 1.1 V. Note that the threshold voltage $V_{th}$ of the input signal IN corresponds to the base-emitter voltage $V_{BE}$ of the transistor $Q_2$ , that is, about 0.7 V. Therefore, in this case

$$V_{OH} \ (1.1 \ V) - V_{th} \ (0.7 \ V) \simeq 0.4 \ V$$
$$V_{th} \ (0.7 \ V) - V_{OL} \ (0.3 \ V) \simeq 0.4 \ V \ .$$

As a result, it is possible for the input threshold voltage $V_{th}$ to be the center value of the output amplitude or to be between the values $V_{OH}$ and $V_{OL}$. However, due to the linear V-I characteristics of the resistor $R_4$ , the noise margins are small, and, therefore, the output signal OUT can suffer from noise generated by the input signal IN and also noise due to the power supply $V_{CC}$.

In Fig. 3, a PN diode D' is provided instead of the resistor $R_4$ of Fig. 2 so as to enhance the noise margins. In this case, the high-level $V_{OH}$ of the output signal OUT corresponds to two stages of conduction state diodes, that is, about 1.5 V (= 2 x 0.7∿0.8 V). Therefore, in this case

$$V_{OH} \ (1.5 \ V) - V_{th} \ (0.7 \ V) \simeq 0.8 \ V$$
$$V_{th} \ (0.7 \ V) - V_{OL} \ (0.3 \ V) \simeq 0.4 \ V$$

Thus, it is difficult to design the threshold voltage $V_{th}$ so that it is the center value of the output amplitude or between $V_{OH}$ and $V_{OL}$. In addition, the diodes D and D' must be formed in individual isolated regions, which can be disadvantageous in respect to high integration.

In Fig. 4, which illustrates an embodiment of the present invention, a clamp circuit formed by a Schottky barrier diode SBD and a PN junction diode D is provided. In this case, the high-level $V_{OH}$ is determined by adding the forward voltage of the Schottky barrier diode SBD, which is, for example, about 0.4 V, and the forward voltage of the diode D, that is, about 0.7~0.8 V. It should be noted that the forward voltage of a Schottky barrier diode is much smaller than the forward voltage of a PN junction diode (diode-connected transistor) when these diodes have about the same dimensions. Therefore, the high-level $V_{OH}$ is about 1.1 to 1.2. Thus,

$$V_{OH} \ (1.1 \ V) - V_{th} \ (0.7 \ V) \simeq 0.4 \ V$$
$$V_{th} \ (0.7 \ V) - V_{OL} \ (0.4 \ V) \simeq 0.4 \ V$$

Therefore, the threshold voltage $V_{th}$ of the input signal IN is approximately the center value of the output amplitude.

In addition, the clamp circuit formed by the Schottky barrier diode SBD and the PN junction diode D can be formed within a single isolated region of a semiconductor device, which can be advantageous in respect to high integration.

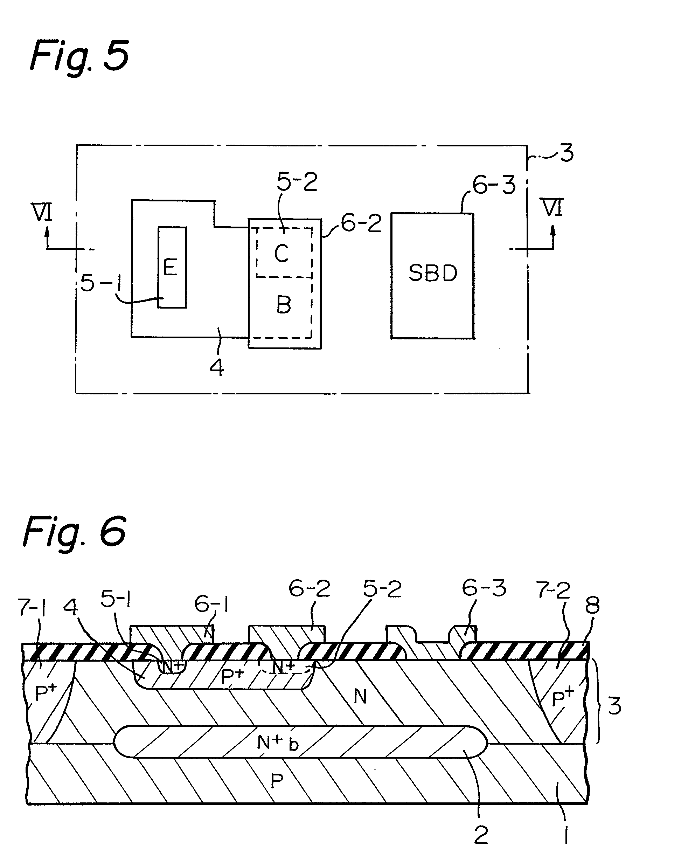

In Fig. 5 and Fig. 6, reference numeral 1 designates a semiconductor substrate lightly doped with impurities of a first conductivity type, such as N-type impurities. An $N^+$-type buried layer 2 having a high concentration is formed on the substrate 1, and, in addition, an N-type epitaxial layer 3 is deposited thereon. Within the epitaxial layer 3 are formed a $P^+$-type impurity diffusion region 4 and $N^+$- -type impurity diffusion regions 5-1 and 5-2. Reference numerals 6-1, 6-2, and 6-3 designate metal layers such as aluminium, reference numerals 7-1 and 7-2 designate isolation layers, and reference numeral 8 designates an insulating layer such as $SiO_2$.

The metal layer 6-3 and the epitaxial layer 3 are connected by the Schottky contact to form the Schottky barrier diode SBD of Fig. 4. Naturally, the metal layer 6-3 serves as an anode while the epitaxial layer 3 serves as a cathode.

The $P^+$-type region 5-1 serves as the emitter region of the diode D, which is a diode-connected transistor, while the $P^+$-type region 5-2 serves as the collector contact region of the diode D.  In addition, the $P^+$-type region 4 serves as the base region of the diode D.  In this case, the base region and the collector region are short-circuited by the metal layer 6-2.

Note that the buried layer 2 and the epitaxial layer 3 collectively serve as not only the collector region of the diode D but also as the cathode of the Schottky barrier diode SBD.  Therefore, the cathode of the Schottky barrier diode SBD is connected to the collector or the anode of the diode D.

Thus, the Schottky barrier diode SBD and the diode D collectively are formed in an isolated region, that is, in one region of the epitaxial layer 3 isolated by the isolation layers 7-1 and 7-2.  In this case, the isolation layers are $P^+$-type layers; however, various isolation techniques, including V-groove isolation polycrystalline backfill, can be used to form the isolation layers.

A TTL circuit embodying the present invention can allow an input threshold voltage V which is the center of the output amplitude.  In addition, high integration can be obtained with such a circuit.

## CLAIMS

1. A transistor-transistor logic circuit comprising:

first and second power supply terminals $(V_{CC}, GND)$;

an input terminal (IN);

an output terminal (OUT);

first and second impedance means $(R_1, R_3)$;

an input transistor $(Q_1)$ having a base connected by said first impedance means to said first power supply terminal, a collector, and at least one emitter connected to the input terminal;

an output transistor $(Q_2)$ having a base connected to the collector of said input transistor, a collector connected to said output terminal and by said second impedance means to said first power supply terminal, and an emitter connected to said second power supply terminal;

a Schottky barrier diode (SBD) having an anode connected to the collector of said output transistor and a cathode; and

a PN junction diode (D) having an anode connected to the cathode of said Schottky barrier diode and a cathode connected to the emitter of said output transistor.

2. A circuit as set forth in claim 1, wherein said Schottky barrier diode and said PN junction diode are collectively formed within one isolated region (3) of a semiconductor device.

3. A circuit as set forth in claim 1, wherein said PN junction diode comprises a diode-connected transistor.

4. A circuit as set forth claim 1, wherein said output transistor comprises a Schottky barrier diode transistor.

5. A transistor-transistor logic circuit comprising:

first and second power supply terminals $(V_{CC}, GND)$;

an input terminal an output terminal

first and second impedance means; an input transistor having a base connected by said first impedance

- 8 -

0080254

means to said first power supply terminal, a collector, and at least one emitter connected to the input terminal;

an output transistor having a base connected to the collector of said input transistor, a collector connected to said output terminal and by said second impedance means to said first power supply terminal, and an emitter connected to said second power supply terminal;

a PN junction diode having an anode connected to the collector of said output transistor and a cathode; and

a Schottky barrier diode having an anode connected to the cathode of said PN junction diode and a cathode connected to the emitter of said output transistor.

## Fig. 1

Vcc — R₁ — R₂ — R₃ — OUT

IN — Q₁ — Q₂ — GND

## Fig. 2

Vcc — R₁ — R₂ — R₃ — OUT

IN — Q₁ — Q₂ — D — R₄ — GND

## Fig. 3

Vcc — R₁ — R₂ — R₃ — OUT

IN — Q₁ — Q₂ — D — D' — GND

## Fig. 4

Vcc — R₁ — R₂ — R₃ — OUT

IN — Q₁ — Q₂ — SBD — D — GND

## Fig. 5

## Fig. 6